# EUROPEAN PATENT SPECIFICATION

(11) **EP 3 806 611 B1**
(45) Date of publication and mention of the grant of the patent: **24.07.2024**
(21) Application number: 18920145.2
(22) Date of filing: 25.05.2018
(51) Int. Cl.: H05K 13/04, H05K 13/00, H05K 13/08

(54) **DETERMINATION DEVICE, COMPONENT MOUNTER HAVING SAME, AND DETERMINATION METHOD**
BESTIMMUNGSVORRICHTUNG, KOMPONENTENMONTIERER DAMIT UND BESTIMMUNGSVERFAHREN
DISPOSITIF DE DÉTERMINATION, DISPOSITIF DE MONTAGE DE COMPOSANT DOTÉ DE CELUI-CI, ET PROCÉDÉ DE DÉTERMINATION

(43) Date of publication of application: 14.04.2021
(73) Proprietor: Fuji Corporation, Chiryu-shi, Aichi 472-8686 (JP)
(72) Inventor: IISAKA, Jun, Chiryu-shi, Aichi 472-8686 (JP); OYAMA, Shigeto, Chiryu-shi, Aichi 472-8686 (JP); NARITA, Haruna, Chiryu-shi, Aichi 472-8686 (JP)
(74) Representative: Grünecker Patent- und Rechtsanwälte PartG mbB
(86) International application number: PCT/JP2018/020184
(87) International publication number: WO 2019/225010

(56) References cited:
- EP-A1- 2 127 800
- JP-A- 2010 278 269
- JP-A- 2014 120 670
- JP-A- 2014 203 966
- US-A1- 2002 014 001

## Description

### Technical Field

The technology disclosed in the present description relates to a determination device that determines an accommodation plan for accommodating backup pins, a component mounter including the determination device, and a determination method for determining an accommodation plan.

### Background Art

Patent Literature 1 discloses an electric component mounting system including a backup pin that supports a printed wiring board, a support table on which the backup pin is disposed, and an accommodation device that accommodates the backup pin therein. In this system, multiple backup pins accommodated in the accommodation device is slidably disposed on the support table provided on the same surface as the accommodation device to support the printed wiring board.

US 2002/014001 A1 relates to a mounting apparatus using supporting members (pins) to support boards to be mounted. The mounting device has a storing device for storing the mounting members and moving the mounting member to a setting position on the supporting surface of the supporting table. Before a production job is started, a manufacturing program including information on the number of pins required for the production is transmitted to the mounting apparatus. The manufacturing program further comprises detailed information on the required position of each pin and the mounting apparatus sets the pins accordingly.

### Patent Literature

Patent Literature 1: JP-A-2002-57498

### Summary of the Invention

### Technical Problem

In general, when different types of printed wiring boards are supported by the backup pins (that is, when different types of jobs are produced), the types or numbers of the backup pins disposed on the support table differ. Therefore, every time a job is changed, it is necessary to replace the type or number of backup pins accommodated in the accommodation device by an operator. The present description provides a technology capable of efficiently accommodating backup pins when different types of jobs are produced in order.

### Solution to Problem

The invention is defined by the features of the independent claims. Any reference to inventions or embodiments not falling within the scope of the independent claims are to be interpreted as examples useful for understanding the invention.

### Brief Description of Drawings

Fig. 1 is a side view schematically illustrating a configuration of a component mounter according to an embodiment.
Fig. 2 is a sectional view taken along line II-II of Fig. 1.
Fig. 3 is a view illustrating an example of a backup pin accommodation section and a backup pin disposition section defined on a backup plate.
Fig. 4 is a flowchart illustrating a process executed by a control device (determination device).
Fig. 5 is a view illustrating an example of job information according to a first embodiment.
Fig. 6 is a view illustrating an example of job information according to a second embodiment.
Fig. 7 is a view illustrating an example of job information according to a modification example.

### Description of Embodiments

In an embodiment disclosed in the present description, for each job acquired by a job acquisition section, a maximum accommodation number acquisition section may acquire a maximum accommodation number of backup pins accommodatable in a backup pin accommodation section in the job. An accommodation plan determination section may determine the number of backup pins accommodated in the backup pin accommodation section before start of production of each of multiple acquired jobs based on a required number of backup pins required in each of the multiple acquired jobs and the maximum accommodation number of backup pins accommodatable in the backup pin accommodation section in each of the multiple acquired jobs. With such a configuration, even when the maximum accommodation number differs for each job, in consideration of this case, the number of backup pins to be accommodated in the backup pin accommodation section is determined, and thus it is possible to efficiently perform the operation of accommodating the backup pins.

In the embodiment disclosed in the present description, the backup pins may include multiple types of the backup pins. For each job, the multiple jobs may define the required number of various types of the backup pins required in the job. For each job, the maximum accommodation number acquisition section may acquire a sum of the numbers of various types of the backup pins accommodatable in the backup pin accommodation section in the job. The accommodation plan determination section may determine the number of each of the various types of the backup pins accommodated in the backup pin accommodation section before the start of production of each of the multiple acquired jobs. With such a configuration, even when the multiple types of the backup pins are used, in consideration of this, the number of backup pins to be accommodated in the backup pin accommodation section is determined, and thus it is possible to efficiently perform the operation of accommodating the backup pins.

In the embodiment disclosed in the present description, the job acquisition section may acquire n jobs, and an i-th (i = 1 to n) job may define a required number xᵢ of backup pins in the i-th job. The maximum accommodation number acquisition section may acquire a maximum accommodation number yi of backup pins in the i-th job. The accommodation plan determination section may (1) determine whether a number x of backup pins required for (i+1)th and subsequent jobs is accommodatable in the backup pin accommodation section in order from the (i+1)th when yᵢ ≧ xᵢ, and (2) set a maximum number among xᵢ to xᵢ₊ⱼ as an accommodation number zᵢ₊ⱼ for (i+j)th job from the i-th job when it is determined that the number of backup pins required from the i-th job to the (i+j)th (j = 0 to m, 0 ≦ m ≦ n) job in the backup pin accommodation section is accommodatable in the backup pin accommodation section. With such a configuration, as the number of backup pins to be accommodated before the start of production of a predetermined job, the number of backup pins capable of producing the multiple jobs is determined, and thus it is not necessary to perform the operation of accommodating the backup pins for each job.

In the embodiment disclosed in the present description, the accommodation plan determination section may determine the number of backup pins accommodated in the backup pin accommodation section before the start of production of each of the multiple acquired jobs so as to minimize the number of times of operations with respect to the backup pin accommodation section, before the start of production of a first job until end of production of a last job with respect to the multiple acquired jobs. In such a configuration, the operation of accommodating the backup pins by the operator can be reduced.

In the embodiment disclosed in the present description, the component mounter may further include a backup plate that supports the backup pins, and the backup pin accommodation section and the backup pin disposition section may be defined on the backup plate. In addition, the accommodation plan determination section may determine an overlapping region that overlaps the board in the backup pin disposition section and determine a non-overlapping region that does not overlap the board in the backup pin accommodation section when the board is supported by the backup pin.

In the embodiment disclosed in the present description, the component mounter may further include a pair of chutes for conveying the board. The pair of chutes may have a fixed chute and a movable chute movable with respect to the fixed chute. The backup pin accommodation section may be provided between the fixed chute and the movable chute. The accommodation plan determination section may determine the accommodation plan such that the backup pins that are not used for support of the board are accommodated on a fixed chute side in an interval between the movable chute and the fixed chute in the non-overlapping region. With such a configuration, when allowing the movable chute to approach the fixed chute, without moving the backup pin accommodated in the backup pin accommodation section, the movable chute and the backup pin can suppress the interference.

### First Embodiment

Hereinafter, with reference to the drawings, component mounter 10 according to an embodiment (hereinafter, referred to as mounter 10) will be described. Mounter 10 is a device for mounting electronic component 4 on circuit board 2. Mounter 10 is referred to as a surface mounting machine or a chip mounter. Normally, mounter 10 is provided together with other board work machines such as a solder printing machine and a board inspection machine to make up a series of mounting lines.

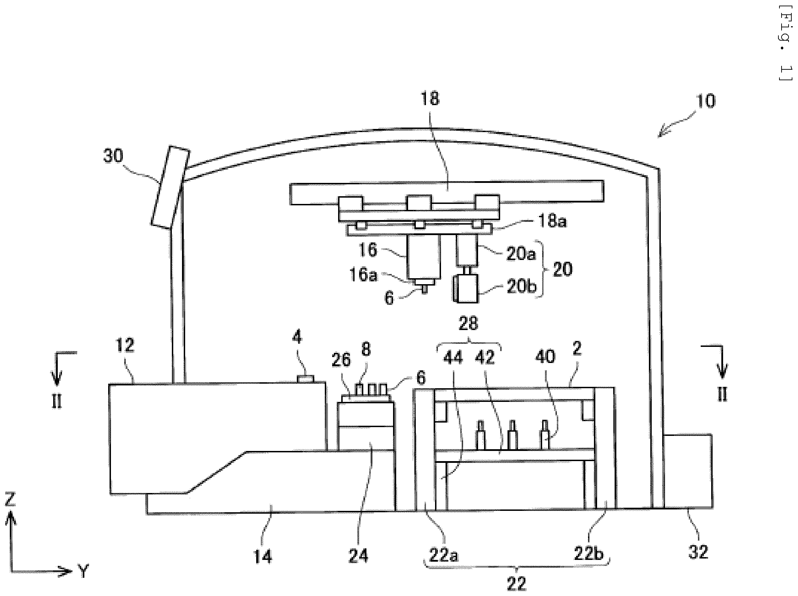

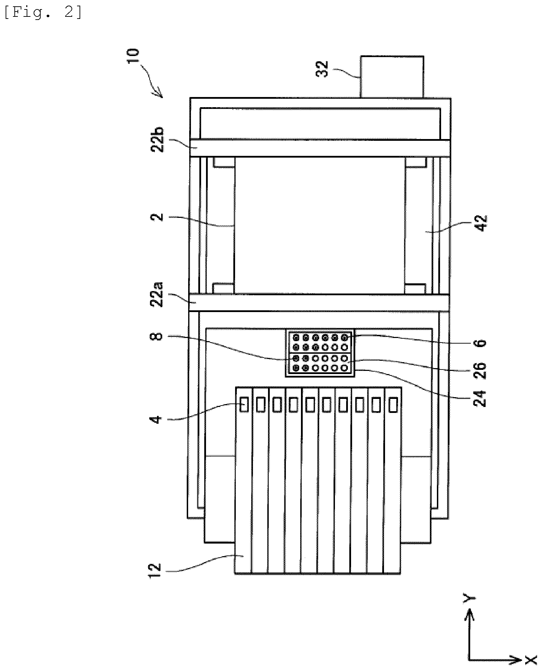

As illustrated in Figs. 1 and 2, mounter 10 includes multiple component feeders 12, feeder holding section 14, mounting head 16, head moving mechanism 18, photographing unit 20, board chute 22, nozzle accommodation section 24, nozzle holder 26, backup device 28, touch panel 30, and control device 32.

Each component feeder 12 accommodates multiple electronic components 4. Component feeder 12 is detachably attached to feeder holding section 14 and supply electronic component 4 to mounting head 16. A specific configuration of component feeder 12 is not particularly limited, but for example, any one of a tape-type feeder which accommodates multiple electronic components 4 on a wound tape, a tray-type feeder that accommodates multiple electronic components 4 on a tray, and a bulk-type feeder that randomly accommodates multiple electronic components 4 within a container may be employed.

Feeder holding section 14 has multiple slots, and component feeder 12 is detachably installed in each of the multiple slots. Feeder holding section 14 may be fixed to mounter 10 or may be detachably attached to mounter 10.

Mounting head 16 is configured such that electronic component suction nozzle 6 (hereinafter, referred to as nozzle 6) for picking up electronic component 4 and backup pin suction nozzle 8 (hereinafter, referred to as nozzle 8) for picking up backup pin 40 to be described later is detachably attached to holding section 16a. Mounting head 16 can move mounted nozzles 6 and 8 in a Z direction (that is, in a vertical direction) and moves nozzle 6 towards and away from component feeder 12, circuit board 2, or accommodated backup pin 40. For example, mounting head 16 can pick up electronic component 4 from component feeder 12 using nozzle 6 and can mount electronic component 4 picked up by nozzle 6 on circuit board 2. Mounting head 16 is not limited to a mounting head having single holding section 16a, but may be a mounting head having multiple holding sections 16a.

Head moving mechanism 18 moves mounting head 16 and photographing unit 20 between component feeder 12 and board chute 22. As one example, head moving mechanism 18 according to the present embodiment is an XY-robot for moving movement base 18a in an X direction and a Y direction. Head moving mechanism 18 is configured of a guide rail for guiding movement base 18a, a moving mechanism for moving movement base 18a along the guide rail, a motor for driving the moving mechanism, and the like. Mounting head 16 and photographing unit 20 are attached to movement base 18a.

Photographing unit 20 is attached to movement base 18a, photographing unit 20 when mounting head 16 is moved also moves integrally. Photographing unit 20 includes camera support section 20a and camera 20b. Camera support section 20a is attached to movement base 18a. Camera 20b is attached below camera support section 20a. Camera 20b is disposed on the sides (Y direction in the drawing) of nozzles 6 and 8 mounted on mounting head 16, and photographs the tip parts of nozzles 6 and 8. In other words, when nozzles 6 and 8 are in a state of picking up the target member, camera 20b photographs the side face of the picked-up target member and the side faces of the tip parts of nozzles 6 and 8. As camera 20b, for example, a CCD camera is used.

Board chute 22 conveys in, supports, and conveys out circuit board 2. Board chute 22 includes fixed chute 22a provided on feeder holding section 14 side, and movable chute 22b provided on the side opposite to feeder holding section 14 with respect to fixed chute 22a. Movable chute 22b is configured to be movable in the Y direction with respect to fixed chute 22a by an actuator (not illustrated). In other words, as movable chute 22b is moved with respect to fixed chute 22a, the interval between fixed chute 22a and movable chute 22b is configured to be variable. Accordingly, board chute 22 can convey in, support, and convey out the circuit boards of various types of dimensions.

Nozzle accommodation section 24 is disposed between component feeder 12 and board chute 22 (specifically, fixed chute 22a). Nozzle accommodation section 24 can accommodate multiple nozzles 6 and 8, and deliver nozzles 6 and 8 to and from mounting head 16. Each of nozzles 6 and 8 is accommodated in nozzle holder 26 attached to nozzle accommodation section 24. Nozzle holder 26 can accommodate multiple types of nozzles 6 and 8. Nozzle holder 26 is detachably attached to nozzle accommodation section 24 and is removed from nozzle accommodation section 24, for example, when the operator exchanges nozzles 6 and 8 in nozzle holder 26.

Backup device 28 includes multiple backup pins 40, backup plate 42, and lifting and lowering mechanism 44.

Backup pin 40 is a member for supporting circuit board 2 from the rear face thereof. By supporting circuit board 2 by backup pin 40, when mounting the components on circuit board 2, the deflection of circuit board 2 is suppressed. Backup pin 40 is configured such that an upper end portion thereof that can abut against circuit board 2 and an lower end portion thereof is detachably attached to the upper face of backup plate 42. Backup pin 40 can be installed on backup plate 42 by using, for example, a magnetic force. Specifically, for example, it is possible to dispose a magnet at the lower end portion of backup pin 40 and to form backup plate 42 with a magnetic material.

Backup plate 42 is configured such that multiple backup pins 40 can be arranged on the upper face thereof. Multiple positions where backup pins 40 can be disposed with respect to backup plate 42 are provided, and depending on the type of circuit board 2 to be supported, backup pins 40 can be appropriately selected and disposed. When circuit board 2 is positioned at a predetermined component mounting position, backup plate 42 is disposed at a position facing the rear face of circuit board 2.

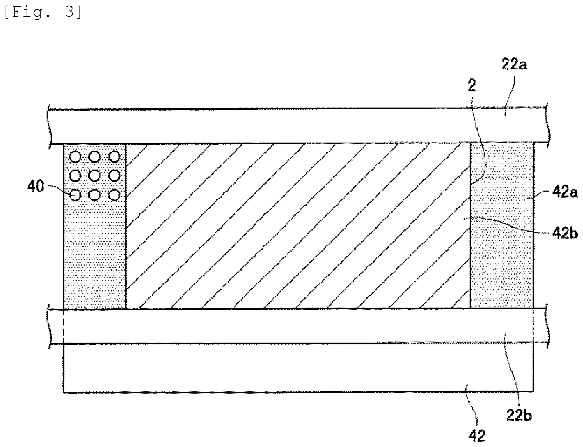

Further, as illustrated in Fig. 3, on backup plate 42, by control device 32, backup pin accommodation section 42a (region hatched by dots) and backup pin disposition section 42b (region hatched in diagonal lines) are defined. Backup pin accommodation section 42a is a region where backup pin 40 which is not used for supporting circuit board 2 is accommodated, and backup pin disposition section 42b is a region where backup pin 40 used for supporting circuit board 2 is installed. More particularly, when backup plate 42 is viewed in a plan view, backup pin accommodation section 42a is a region between fixed chute 22a and movable chute 22b, and is a non-overlapping region that does not overlap circuit board 2 positioned at the component mounting position. As described above, movable chute 22b moves with respect to fixed chute 22a, and the interval between movable chute 22b and fixed chute 22a changes. Therefore, the area of backup pin accommodation section 42a also changes by the movement of movable chute 22b, the maximum number of backup pins 40 accommodatable in backup pin accommodation section 42a also changes. Since backup pin accommodation section 42a is provided between movable chute 22b and fixed chute 22a, it is not necessary to move backup pin 40 to the outside of movable chute 22b or the outside of fixed chute 22a beyond movable chute 22b or fixed chute 22a. Accordingly, it is possible to suppress the increase in dimension of mounter 10 in the Z direction. When backup plate 42 is viewed in a plan view, backup pin disposition section 42b is an overlapping region that overlaps circuit board 2 positioned in the component mounting position.

Lifting and lowering mechanism 44 lifts and lowers backup plate 42 in the up-down direction. When circuit board 2 is positioned at the component mounting position, it is possible to lift backup plate 42 in a state where multiple backup pins 40 are disposed in backup pin disposition section 42b, and to support circuit board 2 by each disposed backup pin 40 from the rear face thereof.

Touch panel 30 is a display device for providing the operator with various types of information, and is a user interface for receiving a command or information from the operator.

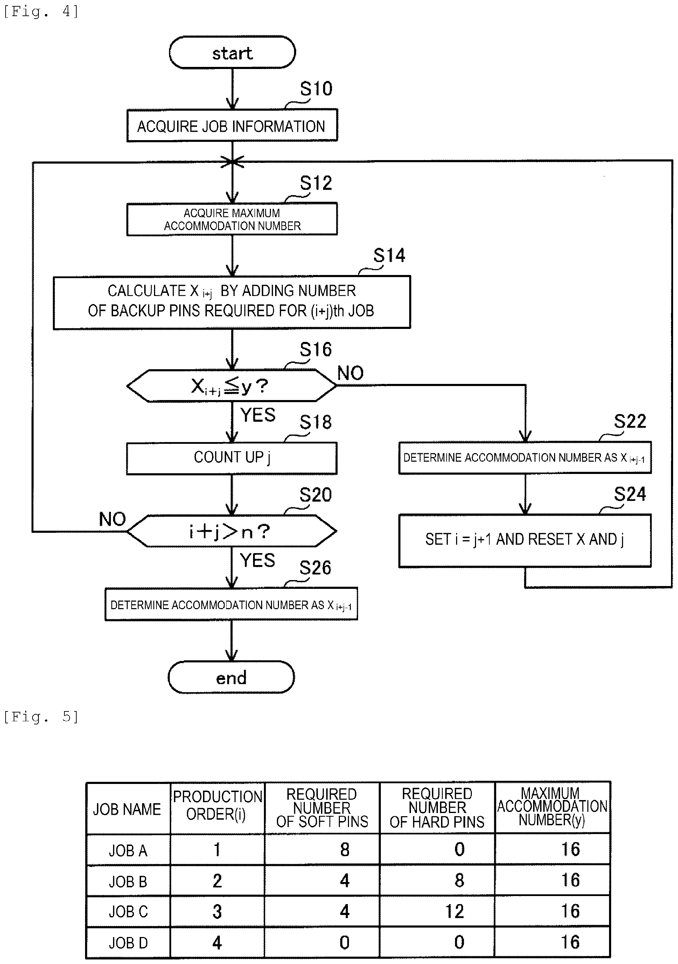

Control device 32 is configured with a computer including a CPU, a ROM, and a RAM. Control device 32, for example, controls the operations of each section of mounter 10 based on the production plan. Control device 32 is also a determination device that determines an accommodation plan for accommodating backup pin 40 in backup pin accommodation section 42a. Hereinafter, with reference to Figs. 4 and 5, a process executed by control device 32 to determine the accommodation plan will be described. In the present embodiment, control device 32 has a function of the determination device that determines the accommodation plan for accommodating backup pin 40, but the determination device may be a device separate from control device 32, or may be a device disposed at a position away from mounter 10.

As illustrated in Figs. 4 and 5, control device 32 determines the accommodation plan for accommodating backup pin 40 in backup pin accommodation section 42a based on the production plan of mounter 10. In the present embodiment, the determination of the accommodation plan for accommodating the two types of backup pins 40 (the soft pin and the hard pin) will be described.

In S10, control device 32 acquires job information. The job information is information indicating the contents of n jobs to be produced and the production order of the n jobs. The i-th (i = 1 to n) job defines the type of circuit board 2 on which the component is mounted, and the required number xᵢ of backup pins 40 required to support the type of circuit board 2. In detail, the required number xᵢ of backup pins 40 is the sum of the required number of soft pins and the required number of hard pins. The job information may be acquired, for example, by the input to touch panel 30 by the operator, or may be acquired by reception from an external device (not illustrated). In the present embodiment, a case where the job information illustrated in Fig. 5 is acquired will be described. In the job information illustrated in Fig. 5, four jobs A to D are produced in this order.

In S12, control device 32 acquires maximum accommodation number y of backup pins accommodatable in backup pin accommodation section 42a. Control device 32 calculates maximum accommodation number y based on the acquired job information. When a certain job is produced, in order to convey target circuit board 2, movable chute 22b is moved with respect to fixed chute 22a in accordance with the size of circuit board 2. When circuit board 2 is supported by backup pin 40, on backup plate 42, within the range between fixed chute 22a and movable chute 22b, control device 32 determines the region that does not overlap supported circuit board 2 as backup pin accommodation section 42a. Then, control device 32 calculates maximum accommodation number y of backup pins 40 accommodatable in backup pin accommodation section 42a from the area of backup pin accommodation section 42a. In the present embodiment, control device 32 calculates that maximum accommodation number y (that is, the sum of the number of soft pins and the number of hard pins) is 16. Maximum accommodation number y may be acquired, for example, by the input to touch panel 30 by the operator, or may be acquired by reception from an external device (not illustrated). Further, in the present embodiment, since the soft pin and the hard pin have the same dimensions, maximum accommodation number y does not change between the soft pin and the hard pin.

In S14, control device 32 calculates number Xᵢ₊ⱼ required up to the (i+j)th job based on required number Xᵢ₊ⱼ of backup pins in the (i+j)th (j = 0 to m, 0 ≦ m ≦n) job. Specifically, control device 32 first adds the required number of backup pins required for job A to be produced first (i = 1, j = 0). As illustrated in Fig. 5, since eight soft pins and zero hard pins (x₁ = 8) are required in job A, control device 32 calculates that X₁ = 8.

In S16, control device 32 determines whether Xᵢ₊ⱼ is maximum accommodation number y or less (S16). Here, since X₁ = 8 and y = 16, control device 32 determines YES in S16, and proceeds to S18.

In S18, control device 32 counts up j, and proceeds to S20. In S20, control device 32 determines whether i+j exceeds the total number of jobs n based on the job information. Here, since i+j = 2 and n = 4, control device 32 determines NO in S20 (that is, determines that the series of processes for all n jobs indicated by the job information has not been completed), and executes S14 again.

Next, in S14, control device 32 calculates number Xᵢ₊ⱼ required up to second job B based on the required number Xᵢ₊ⱼ of backup pins in second (i = 1 and j = 1) job B. As illustrated in FIG. 5, since four soft pins and eight hard pins (x₂ = 12) are required for second job B, control device 32 adds the number (that is, eight hard pins), which is to be insufficient for the number required for second job B, to X₁ (eight soft pins and zero hard pins). Therefore, control device 32 here calculates X₂ = 16. Then, control device 32 determines YES in S16 because X₂ = 16 and y = 16, counts up j in S18, determines NO in S20 because i+j = 3 and n = 4, and returns to S14 again.

Next, in S14, control device 32 calculates number Xᵢ₊ⱼ required up to third job C based on the required number Xᵢ₊ⱼ of backup pins in third (i = 1 and j = 2) job C. As illustrated in Fig. 5, since four soft pins and twelve hard pins (x₃ = 16) are required for third job C, control device 32 adds the number (that is, four hard pins), which is to be insufficient for the number required for third job C, to X₂ (eight soft pins and eight hard pins). Therefore, control device 32 here calculates X₃ = 20. Then, since X₃ = 20 and y = 16, control device 32 determines NO in S16, and proceeds to S22.

In S22, control device 32 determines the number of backup pins 40 to be accommodated in backup pin accommodation section 42a before the start of production of the i-th job, as Xᵢ₊ⱼ₋₁. In other words, control device 32 determines the accommodation number as the number immediately before calculated number Xᵢ₊ⱼ exceeds maximum accommodation number y. Here, since i = 1 and j = 2, control device 32 determines the number of backup pins 40 accommodated before the start of production of first job A, as sixteen in total, that is, eight soft pins and eight hard pins, which is the number of backup pins 40 required from first job A to second job B. Then, in S24, after setting i = j+1 (that is, i = 3), control device 32 resets j and Xᵢ₊ⱼ to 0, and proceeds to S14 again.

Thereafter, control device 32 executes S14 to S20 for third job C and executes S14 to S18 for fourth job D in the same manner as the above-described process. Thereafter, since i = 1 and j = 4, control device 32 determines YES in S20 (that is, determines that a series of processes for all n jobs indicated by the job information has been completed), and proceeds to S26.

In S26, control device 32 determines the number of backup pins 40 to be accommodated in backup pin accommodation section 42a before the start of production of the i-th job, as Xᵢ₊ⱼ₋₁. Here, since i = 3 and j = 2, control device 32 determines the number of backup pins 40 accommodated before the start of production of third job C, as sixteen in total, that is, four soft pins and twelve hard pins, which is the number of backup pins 40 required from third job C to fourth job D. After executing S26, control device 32 completes the series of processes.

As described above, in mounter 10 according to the present embodiment, when the required number of backup pins 40 in a certain job (for example, job A) is equal to or less than the maximum accommodation number of backup pins 40 accommodatable in backup pin accommodation section 42a (YES in S16), control device 32 calculates the number of backup pins required up to a job (for example, job B) to be produced next to certain job (S18, S14). Then, control device 32 repeatedly executes the above-described processes until the calculated number becomes larger than the maximum accommodation number. When the calculated number becomes larger than the maximum accommodation number (NO in S16), the number calculated immediately before is determined as the accommodation number of backup pins before the start of production of the certain job (S24). In this manner, in mounter 10 according to the present embodiment, as the number of backup pins 40 accommodated in backup pin accommodation section 42a before the start of production of a certain job, the number of backup pins capable of producing the multiple jobs is determined, and thus it is not necessary for the operator to perform the operation of accommodating backup pins 40 for each job.

Specifically, in the present embodiment, the operator accommodates eight soft pins and eight hard pins before the start of production of job A, takes out four soft pins before the start of production of job C, and accommodates four hard pins, and thus mounter 10 can produce all of jobs A to D. Therefore, the operator can produce all of jobs A to D by performing the operation with respect to backup pin accommodation section 42a only twice. In other words, according to mounter 10 of the present embodiment, the number of operations performed by the operator with respect to backup pin accommodation section 42a is minimized in a period from before the start of production of first job A up to the end of production of last job D, with respect to multiple acquired jobs A to D. In this manner, in mounter 10 according to the present embodiment, compared to the conventional art, it is possible to reduce the amount of operations of accommodating backup pin 40 in backup pin accommodation section 42a.

When determining the number of backup pins 40 to be accommodated in backup pin accommodation section 42a, control device 32 may determine that backup pin 40 is accommodated on fixed chute 22a side with an interval between fixed chute 22a and movable chute 22b in backup pin accommodation section 42a. Accordingly, when approaching movable chute 22b with respect to fixed chute 22a, without moving backup pin 40 accommodated in backup pin accommodation section 42a, it is possible to suppress interference between movable chute 22b and backup pin 40.

### Second Embodiment

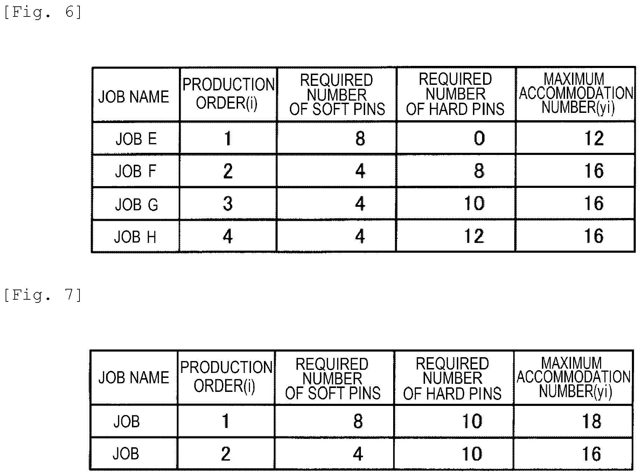

Next, a mounter according to a second embodiment will be described. In the present embodiment, the configuration of the mounter is the same as that of the first embodiment, but as illustrated in Fig. 6, the number of backup pins 40 accommodatable in backup pin accommodation section 42a differs for each acquired job. Hereinafter, a process executed by control device 32 to determine the accommodation plan in the second embodiment will be described.

S10 is the same as that of being described in the first embodiment. In S12, control device 32 acquires maximum accommodation number of backup pins accommodatable in backup pin accommodation section 42a for each acquired job. In other words, control device 32 acquires maximum accommodation number yi of backup pins 40 in the i-th job. In the present embodiment, as illustrated in Fig. 6, control device 32 acquires maximum accommodation number yi (that is, the sum of numbers of soft pins and hard pins) for each of jobs A to D.

S14 is the same as that of being described in the first embodiment except that Xᵢ₊ⱼ is calculated for first (i = 1, j = 0) job E illustrated in Fig. 6. In S16, control device 32 determines whether Xᵢ₊ⱼ is equal to or less than maximum accommodation number yi of backup pins in the i-th job (S16). In other words, in the present embodiment, control device 32 executes the process by replacing S16 with "Xᵢ₊ⱼ ≦ yᵢ?". Here, since X₁ = 8 and y₁ = 12, control device 32 determines YES in S16, and proceeds to S18.

S18 is the same as that of being described in the first embodiment. In S20, since i+j = 2 and n = 4, control device 32 determines NO in S20 and executes S14 again.

In S14, control device 32 calculates number Xᵢ₊ⱼ required up to second (i = 1, j = 1) job F. As illustrated in Fig. 6, since four soft pins and eight hard pins are required for second job F, control device 32 adds the number (that is, eight hard pins), which is to be insufficient for the number required for second job F, to X₁ (eight soft pins and zero hard pins). Therefore, control device 32 here calculates X2 = 16. Then, since X₂ = 16 and y₁ = 12, control device 32 determines NO in S16, and proceeds to S22.

S22 is the same as that of being described in the first embodiment. In other words, here, since control device 32 has i = 1 and j = 1, control device 32 determines the number of backup pins 40 accommodated before the start of production of first job E, as eight in total, that is, eight soft pins and zero hard pins, which is the number of backup pins 40 required up to first job E. Then, in S24, after setting i = j+1 (that is, i = 2), control device 32 resets j and Xᵢ₊ⱼ to 0, and proceeds to S14 again.

Thereafter, control device 32 executes S14 to S20 for second to fourth jobs F to H in the same manner as that in the above-described processes. Thereafter, since i = 2 and j = 3, control device 32 determines YES in S20, and proceeds to S26. In S26, control device 32 determines the number of backup pins 40 to be accommodated before the start of production of second job F, as sixteen in total, that is, four soft pins and twelve hard pins, which is the number of backup pins 40 required from second job F to fourth job H. After executing S26, control device 32 completes the series of processes.

As described above, in the present embodiment, the maximum accommodation number of backup pins accommodatable in backup pin accommodation section 42a differs for each job. In the mounter according to the present embodiment, even in such a case, in consideration of this, the accommodation plan is determined, and thus the amount of operations of accommodating backup pin 40 in backup pin accommodation section 42a can be reduced.

### (Correspondence Relationship)

Mounting head 16 is an example of the "moving mechanism". Circuit board 2 is an example of the "board". S10 is an example of a process executed by the "job acquisition section". S12 is an example of a process executed by the "maximum accommodation number acquisition section". S14 to S26 are examples of processes executed by the "accommodation plan determination section".

In each of the above-described embodiments, it is assumed that the soft pin and the hard pin have substantially the same size, but the technology disclosed in the present description can be applied even when the size of the soft pin and the size of the hard pin are different from each other. In addition, the type of backup pin 40 is not limited to 2 types, and may be 1 type or 3 or more types.

Further, in the above-described second embodiment, a configuration in which the number obtained by adding the required numbers of backup pins for each job in order until exceeding the maximum accommodation number of backup pins in a certain job is calculated is applied, but in addition to the comparison between the maximum accommodation number of backup pins in a certain job and the calculated number, the comparison between the maximum accommodation number of backup pins in a job to be added and the calculated number may be executed. Such a configuration is useful, for example, when the job information illustrated in Fig. 7 is acquired. In other words, number X₂ (= 18) required from first job I to second job J is equal to or less than maximum accommodation number y₁ (= 18) in first job I (YES in S16), but when number X₂ is larger than maximum accommodation number y₂ in second job J, all backup pins 40 cannot be accommodated in backup pin accommodation section 42a when producing second job J. In consideration of such a situation, in the second embodiment, in a case of YES in S16, the process of "Xᵢ₊ⱼ ⊏ yᵢ₊ⱼ?" may be executed before S18. When a negative determination is made in the process, the process may proceed to S22.

The invention is limited by the appended claims.

### Reference Signs List

2: circuit board, 4: electronic component, 6: electronic component suction nozzle, 8: backup pin suction nozzle, 10: component mounter, 12: component feeder, 14: feeder holding section, 16: mounting head, 16a: holding section, 18: head moving mechanism, 18a: movement base, 20: photographing unit, 20a: camera support section, 20b: camera, 22: board chute, 22a: fixed chute, 22b: movable chute, 24: nozzle accommodation section, 26: nozzle holder, 28: backup device, 30: touch panel, 32: control device, 40: backup pin, 42: backup plate, 42a: backup pin accommodation section, 42b: backup pin disposition section, 44: lifting and lowering mechanism

## Claims

1. A determination device configured to determine an accommodation plan for accommodating backup pins (40) in a backup pin accommodation section (42a) in a component mounter (10) that includes the backup pin accommodation section (42a), a backup pin disposition section (42b), and a moving mechanism (18), the component mounter (10) disposing the backup pins, being accommodated in the backup pin accommodation section (42a), by moving the backup pins (40) to a board support position on the backup pin disposition section (42b) by the moving mechanism (18), and mounting a component on a board supported by using the backup pins (40), wherein the backup pin accommodation section (42a) is a region where backup pin (40) which is not used for supporting the board is accommodated, and backup pin disposition section (42b) is a region where backup pin (40) used for supporting board is installed, the determination device comprising:
a job acquisition section configured to acquire a job to be produced for defining a type of the board on which the component is mounted, and a required number of backup pins (40) to be required to support the type of the board;
a maximum accommodation number acquisition section configured to acquire a maximum accommodation number of backup pins (40) accommodatable in the backup pin accommodation section (42a) in the job;
**characterized by**
an accommodation plan determination section configured to determine the number of backup pins (40) to be accommodated in the backup pin accommodation section (42a) before starting production of each of multiple acquired jobs to be produced, the determination being made based on the required number of backup pins (40), which is required in each of the multiple acquired jobs to be produced, and the maximum accommodation number of backup pins (40) accommodatable in the backup pin accommodation section (42a), when a production order of the multiple jobs to be produced acquired by the job acquisition section is determined, wherein
the accommodation plan determination section is configured to determine the number of backup pins (40) accommodated in the backup pin accommodation section (42a) before the start of production of each of the multiple acquired jobs to be produced so as to minimize the number of times of operations with respect to the backup pin accommodation section (42a), before the start of production of a first job to be produced until end of production of a last job to be produced with respect to the multiple acquired jobs to be produced.

2. The determination device according to claim 1, wherein
the maximum accommodation number acquisition section is configured to acquire the maximum accommodation number of backup pins (40) accommodatable in the backup pin accommodation section (42a) in the job to be produced for each job to be produced acquired by the job acquisition section, and
the accommodation plan determination section is configured to determine the number of backup pins (40) accommodated in the backup pin accommodation section (42a) before the start of production of each of the multiple acquired jobs to be produced based on the required number of backup pins (40) required in each of the multiple acquired jobs to be produced and the maximum accommodation number of backup pins (40) accommodatable in the backup pin accommodation section (42a) in each of the multiple acquired jobs to be produced.

3. The determination device according to claim 1 or 2, wherein
the backup pins (40) include multiple types of the backup pins (40),
the multiple jobs to be produced define, for each job to be produced, the required number of various types of the backup pins (40) required in the job to be produced,
the maximum accommodation number acquisition section is configured to acquire a sum of the numbers of various types of the backup pins (40) accommodatable in the backup pin accommodation section (42a), and the accommodation plan determination section is configured to determine the number of each of the various types of the backup pins (40) accommodated in the backup pin accommodation section (42a) before the start of production of each of the multiple acquired jobs to be produced.

4. The determination device according to claim 2, wherein
the job acquisition section acquires n jobs to be produced,
an i-th (i = 1 to n) job to be produced defines a required number xi of backup pins (40) in the i-th job to be produced,
the maximum accommodation number acquisition section is configured to acquire a maximum accommodation number yi of backup pins (40) in the i-th job to be produced, and
the accommodation plan determination section
(1) is configured to determine whether a number X of backup pins (40) required for (i+1)th and subsequent jobs to be produced is accommodatable in the backup pin accommodation section (42a) in order from the (i+1)th job to be produced when yi □ xi, and
(2) is configured to set a maximum number among xi to xi+j as an accommodation number for jobs to be produced from the i-th job to be produced to an (i+j)th (j = 0 to m, 0 □ m □ n) job to be produced from the i-th job to be produced when it is determined that the number of backup pins (40) required up to the (i+j)th job to be produced from the i-th job to be produced in the backup pin accommodation section (42a) is accommodatable in the backup pin accommodation section (42a).

5. The determination device according to any one of claims 1 to 4, wherein the component mounter (10) further includes a backup plate that supports the backup pin (40),
the backup pin accommodation section (42a) and the backup pin disposition section (42b) are defined on the backup plate, and
the accommodation plan determination section is configured to determine an overlapping region that overlaps the board in the backup pin disposition section (42b) and to determine a non-overlapping region that does not overlap the board in the backup pin accommodation section (42a) when the board is supported by the backup pin (40).

6. The determination device according to claim 5, wherein
the component mounter (10) further includes a pair of chutes for conveying the board, the pair of chutes has a fixed chute and a movable chute movable with respect to the fixed chute,
the backup pin accommodation section (42a) is provided between the fixed chute and the movable chute, and the accommodation plan determination section is configured to determine the accommodation plan such that the backup pins (40) that are not used for support of the board are accommodated on a fixed chute side in an interval between the movable chute and the fixed chute in the non-overlapping region.

7. A component mounter (10) comprising:
a mounting machine configured to mount a component on a board; and
the determination device according to any one of claims 1 to 6.

8. A determination method for determining an accommodation plan for accommodating backup pins (40) in a backup pin accommodation section (42a) in a component mounter (10) that includes the backup pin accommodation section (42a), a backup pin disposition section (42b), and a moving mechanism (18), disposes the backup pins (40) accommodated in the backup pin accommodation section (42a) by moving the backup pins (40) to a board support position on the backup pin disposition section (42b) by the moving mechanism (18), and mounts a component on a board supported by using the backup pins (40), wherein the
backup pin accommodation section (42a) is a region where backup pin (40) which is not used for supporting the board is accommodated, and backup pin disposition section (42b) is a region where backup pin (40) used for supporting board is installed, the method causing a computer to execute the following processes, comprising:
a job acquisition process of acquiring a job to be produced for defining a type of the board on which the component is mounted, and a required number of backup pins (40) to be required to support the type of the board;
a maximum accommodation number acquisition process of acquiring a maximum accommodation number of backup pins accommodatable in the backup pin accommodation section (42a) in the job;
**characterized by**
an accommodation plan determination process of determining the number of backup pins (40) to be accommodated in the backup pin accommodation section (42a) before starting production of each of multiple acquired jobs to be produced based on the required number of backup pins (40) required in each of the multiple acquired jobs to be produced and the maximum accommodation number of backup pins (40) accommodatable in the backup pin accommodation section (42a) when a production order of the multiple jobs to be produced, wherein
the accommodation plan determination process determines the number of backup pins (40) accommodated in the backup pin accommodation section (42a) before the start of production of each of the multiple acquired jobs to be produced so as to minimize the number of times of operations with respect to the backup pin accommodation section (42a), before the start of production of a first job to be produced until end of production of a last job to be produced with respect to the multiple acquired jobs to be produced.

## Patentansprüche

1. Bestimmungsvorrichtung, die so konfiguriert ist, dass sie einen Unterbringungsplan zum Unterbringen von Sicherungsstiften (40) in einem Sicherungsstift-Unterbringungsabschnitt (42a) in einem Bauteilhalter (10) bestimmt, der den Sicherungsstift-Unterbringungsabschnitt (42a), einen Sicherungsstift-Anordnungsabschnitt (42b) und einen Bewegungsmechanismus (18) umfasst, wobei der Bauteilhalter (10) die Sicherungsstifte anordnet, die in dem Sicherungsstift-Unterbringungsabschnitt (42a) untergebracht sind, durch Bewegen der Stützstifte (40) zu einer Leiterplattenstützposition auf dem Stützstiftanordnungsabschnitt (42b) durch den Bewegungsmechanismus (18), und Montieren einer Komponente auf einer Leiterplatte, die unter Verwendung der Stützstifte (40) gestützt wird, wobei der Stützstiftaufnahmeabschnitt (42a) ein Bereich ist, in dem der Stützstift (40), der nicht zum Stützen der Leiterplatte verwendet wird, aufgenommen wird, und der Stützstiftanordnungsabschnitt (42b) ein Bereich ist, in dem der Stützstift (40), der zum Stützen der Leiterplatte verwendet wird, installiert wird, wobei die Bestimmungsvorrichtung umfasst:
einen Auftragserfassungsabschnitt, der so konfiguriert ist, dass er einen herzustellenden Auftrag zum Definieren eines Typs der Platine, auf der die Komponente montiert ist, und einer erforderlichen Anzahl von Sicherungsstiften (40), die zum Unterstützen des Typs der Platine erforderlich sind, erfasst
einen Abschnitt zur Erfassung der maximalen Aufnahmezahl, der so konfiguriert ist, dass er eine maximale Aufnahmezahl von Sicherungsstiften (40) erfasst, die in dem Abschnitt (42a) zur Aufnahme von Sicherungsstiften in dem Auftrag untergebracht werden können;
**gekennzeichnet durch**
einen Unterbringungsplan-Bestimmungsabschnitt, der konfiguriert ist, um die Anzahl von Sicherungsstiften (40) zu bestimmen, die in dem Sicherungsstift-Unterbringungsabschnitt (42a) unterzubringen sind, bevor die Produktion jedes von mehreren erfassten, zu produzierenden Aufträgen gestartet wird, wobei die Bestimmung auf der Grundlage der erforderlichen Anzahl von Sicherungsstiften (40), die in jedem der mehreren erfassten, zu produzierenden Aufträge erforderlich ist, und der maximalen Unterbringungsanzahl von Sicherungsstiften (40), die in dem Sicherungsstift-Unterbringungsabschnitt (42a) unterbringbar ist, vorgenommen wird, wenn eine Produktionsreihenfolge der mehreren zu produzierenden Aufträge, die von dem Auftragserfassungsabschnitt erfasst werden, bestimmt wird, wobei
der Unterbringungsplan-Bestimmungsabschnitt konfiguriert ist, um die Anzahl von Sicherungsstiften (40), die in dem Sicherungsstift-Unterbringungsabschnitt (42a) untergebracht sind, vor dem Beginn der Produktion jedes der mehreren erfassten, zu produzierenden Aufträge zu bestimmen, um so die Anzahl von Betriebszeiten in Bezug auf den Sicherungsstift-Unterbringungsabschnitt (42a) zu minimieren, vor dem Beginn der Produktion eines ersten zu produzierenden Auftrags bis zum Ende der Produktion eines letzten zu produzierenden Auftrags in Bezug auf die mehreren erfassten, zu produzierenden Aufträge.

2. Bestimmungsvorrichtung nach Anspruch 1, wobei
der Abschnitt zur Erfassung der maximalen Unterbringungsanzahl so konfiguriert ist, dass er die maximale Unterbringungsanzahl von Sicherungsstiften (40) erfasst, die in dem Abschnitt (42a) zur Unterbringung von Sicherungsstiften in dem herzustellenden Auftrag für jeden durch den Auftragserfassungsabschnitt erfassten herzustellenden Auftrag unterbringbar sind, und
der Unterbringungsplan-Bestimmungsabschnitt so konfiguriert ist, dass er die Anzahl der Sicherungsstifte (40), die in dem Sicherungsstift-Unterbringungsabschnitt (42a) untergebracht sind, vor dem Beginn der Produktion jedes der mehreren erworbenen, zu produzierenden Aufträge bestimmt, basierend auf der erforderlichen Anzahl von Sicherungsstiften (40), die in jedem der mehreren erworbenen, zu produzierenden Aufträge erforderlich sind, und der maximalen Unterbringungsanzahl von Sicherungsstiften (40), die in dem Sicherungsstift-Unterbringungsabschnitt (42a) in jedem der mehreren erworbenen, zu produzierenden Aufträge untergebracht werden können.

3. Bestimmungsvorrichtung nach Anspruch 1 oder 2, wobei
die Sicherungsstifte (40) mehrere Typen von Sicherungsstiften (40) umfassen,
die mehreren herzustellenden Aufträge für jeden herzustellenden Auftrag die erforderliche Anzahl von verschiedenen Typen der Sicherungsstifte (40) definieren, die in dem herzustellenden Auftrag erforderlich sind,
der Abschnitt zum Erfassen der maximalen Unterbringungsanzahl so konfiguriert ist, dass er eine Summe der Anzahl verschiedener Typen der Sicherungsstifte (40) erfasst, die in dem Sicherungsstift-Unterbringungsabschnitt (42a) untergebracht werden können, und der Unterbringungsplan-Bestimmungsabschnitt so konfiguriert ist, dass er die Anzahl jedes der verschiedenen Typen der Sicherungsstifte (40), die in dem Sicherungsstift-Unterbringungsabschnitt (42a) untergebracht sind, vor dem Beginn der Produktion jedes der mehreren erfassten, zu produzierenden Aufträge bestimmt.

4. Bestimmungsvorrichtung nach Anspruch 2, wobei
der Auftragserfassungsabschnitt n zu produzierende Aufträge erfasst,
ein i-ter (i = 1 bis n) zu produzierender Auftrag eine erforderliche Anzahl xi von Sicherungsstiften (40) in dem i-ten zu produzierenden Auftrag definiert,
der Abschnitt zur Erfassung der maximalen Unterbringungszahl ist so konfiguriert, dass er eine maximale Unterbringungszahl yi von Sicherungsstiften (40) in dem i-ten zu produzierenden Auftrag erfasst, und
der Unterbringungsplan-Bestimmungsabschnitt
(1) konfiguriert ist, um zu bestimmen, ob eine Anzahl X von Sicherungsstiften (40), die für den (i+1)-ten und nachfolgende zu produzierende Aufträge erforderlich ist, in dem Sicherungsstift-Unterbringungsabschnitt (42a) in der Reihenfolge von dem (i+1)-ten zu produzierenden Auftrag unterbringbar ist, wenn yi □ xi, und
(2) konfiguriert ist, um eine maximale Anzahl unter xi bis xi+j als eine Unterbringungsanzahl für zu produzierende Jobs vom i-ten zu produzierenden Job bis zu einem (i+j)-ten (j = 0 bis m, 0 □ m □ n) zu produzierenden Auftrag aus dem i-ten zu produzierenden Auftrag, wenn festgestellt wird, dass die Anzahl der Sicherungsstifte (40), die bis zum (i+j)-ten zu produzierenden Auftrag aus dem i-ten zu produzierenden Auftrag im Sicherungsstift-Unterbringungsabschnitt (42a) erforderlich ist, in dem Sicherungsstift-Unterbringungsabschnitt (42a) unterbringbar ist.

5. Bestimmungsvorrichtung nach einem der Ansprüche 1 bis 4, wobei der Bauteilhalter (10) ferner eine Sicherungsplatte aufweist, die den Sicherungsstift (40) trägt,
der Aufnahmeabschnitt (42a) für den Stützstift und der Dispositionsabschnitt (42b) für den Stützstift auf der Stützplatte definiert sind, und
der Aufnahmeplan-Bestimmungsabschnitt konfiguriert ist, um einen überlappenden Bereich zu bestimmen, der die Platine in dem Sicherungsstift-Anordnungsabschnitt (42b) überlappt, und um einen nicht überlappenden Bereich zu bestimmen, der die Platine in dem Sicherungsstift-Aufnahmeabschnitt (42a) nicht überlappt, wenn die Platine von dem Sicherungsstift (40) getragen wird.

6. Bestimmungsvorrichtung nach Anspruch 5, wobei
der Bauteilhalter (10) ferner ein Paar von Rutschen zum Transportieren der Platine aufweist,
das Rutschenpaar eine feste Rutsche und eine bewegliche Rutsche aufweist, die in Bezug auf die feste Rutsche beweglich ist,
der Unterbringungsabschnitt (42a) für Sicherungsstifte zwischen der festen Rutsche und der beweglichen Rutsche vorgesehen ist, und der Unterbringungsplan-Bestimmungsabschnitt so konfiguriert ist, dass er den Unterbringungsplan so bestimmt, dass die Sicherungsstifte (40), die nicht zur Unterstützung der Platte verwendet werden, auf einer Seite der festen Rutsche in einem Intervall zwischen der beweglichen Rutsche und der festen Rutsche in dem nicht überlappenden Bereich untergebracht werden.

7. Bauteil-Montagevorrichtung (10), umfassend:
eine Montagemaschine, die so konfiguriert ist, dass sie ein Bauteil auf einer Platine montiert; und
die Bestimmungsvorrichtung nach einem der Ansprüche 1 bis 6.

8. Bestimmungsverfahren zum Bestimmen eines Unterbringungsplans zum Unterbringen von Sicherungsstiften (40) in einem Sicherungsstift-Unterbringungsabschnitt (42a) in einer Bauteil-Bestückungsmaschine (10), die den Sicherungsstift-Unterbringungsabschnitt (42a), einen Sicherungsstift-Anordnungsabschnitt (42b) und einen Bewegungsmechanismus (18) aufweist, die Sicherungsstifte (40), die in dem Sicherungsstift-Unterbringungsabschnitt (42a) untergebracht sind, durch Bewegen der Sicherungsstifte (40) zu einer Platinenstützposition auf dem Sicherungsstift-Anordnungsabschnitt (42b) durch den Bewegungsmechanismus (18) anordnet, und ein Bauteil auf einer unter Verwendung der Stützstifte (40) gestützten Platine montiert, wobei der StützstiftAufnahmeabschnitt (42a) ein Bereich ist, in dem der Stützstift (40), der nicht zum Stützen der Platine verwendet wird, aufgenommen wird, und der Stützstift-Anordnungsabschnitt (42b) ein Bereich ist, in dem der zum Stützen der Platine verwendete Stützstift (40) installiert wird, wobei das Verfahren einen Computer veranlasst, die folgenden Prozesse auszuführen, umfassend:
einen Auftragserfassungsprozess zum Erfassen eines zu erstellenden Auftrags zum Definieren eines Typs der Platine, auf der das Bauteil montiert ist, und einer erforderlichen Anzahl von Sicherungsstiften (40), die zum Unterstützen des Typs der Platine erforderlich sind;
einen Maximalaufnahmezahl-Erfassungsprozess zum Erfassen einer maximalen Aufnahmezahl von Sicherungsstiften, die in dem Sicherungsstift-Aufnahmeabschnitt (42a) in dem Auftrag aufgenommen werden können;
**gekennzeichnet durch**
einen Unterbringungsplan-Bestimmungsprozess des Bestimmens der Anzahl von Sicherungsstiften (40), die in dem Sicherungsstift-Unterbringungsabschnitt (42a) untergebracht werden sollen, bevor die Produktion jedes von mehreren erworbenen, herzustellenden Jobs gestartet wird, basierend auf der erforderlichen Anzahl von Sicherungsstiften (40), die in jedem der mehreren erworbenen, herzustellenden Jobs erforderlich sind, und der maximalen Unterbringungsanzahl von Sicherungsstiften (40), die in dem Sicherungsstift-Unterbringungsabschnitt (42a) untergebracht werden können, wenn eine Produktionsreihenfolge der mehreren herzustellenden Jobs besteht, wobei
der Unterbringungsplan-Bestimmungsprozess die Anzahl von Sicherungsstiften (40), die in dem Sicherungsstift-Unterbringungsabschnitt (42a) untergebracht sind, vor dem Beginn der Produktion jedes der mehreren zu produzierenden erworbenen Aufträge bestimmt, um die Anzahl der Zeiten von Operationen in Bezug auf den Sicherungsstift-Unterbringungsabschnitt (42a) zu minimieren, vor dem Beginn der Produktion eines ersten zu produzierenden Auftrags bis zum Ende der Produktion eines letzten zu produzierenden Auftrags in Bezug auf die mehreren zu produzierenden erworbenen Aufträge.

## Revendications

1. Dispositif de détermination configuré pour déterminer un plan de logement pour loger des broches d'appui (40) dans une section de logement de broches d'appui (42a) dans un dispositif de montage de composants (10) qui comprend la section de logement de broches d'appui (42a), une section de disposition de broches d'appui (42b), et un mécanisme de déplacement (18), le dispositif de montage de composants (10) disposant les broches d'appui, qui sont logées dans la section de logement de broches d'appui (42a), en déplaçant les broches d'appui (40) vers une position de support de carte sur la section de disposition de broches d'appui (42b) par le mécanisme de déplacement (18), et montant un composant sur une carte supportée en utilisant les broches d'appui (40), dans lequel la section de logement de broches d'appui (42a) est une région dans laquelle la broche d'appui (40) qui n'est pas utilisée pour supporter la carte est logée, et la section de disposition de broches d'appui (42b) est une région dans laquelle la broche d'appui (40) utilisée pour supporter la carte est installée, le dispositif de détermination comprenant :
une section d'acquisition de travail configurée pour acquérir un travail à produire pour définir un type de carte sur laquelle le composant est monté, et un nombre requis de broches d'appui (40) devant être requises pour supporter le type de la carte ;
une section d'acquisition de nombre de logement maximal configurée pour acquérir un nombre de logement maximal de broches d'appui (40) pouvant être logées dans la section de logement de broches d'appui (42a) dans le travail ;
**caractérisé par**
une section de détermination de plan de logement configurée pour déterminer le nombre de broches d'appui (40) à loger dans la section de logement de broches d'appui (42a) avant de commencer la production de chacun des multiples travaux acquis à produire, la détermination étant effectuée sur la base du nombre requis de broches d'appui (40), qui est requis dans chacun des multiples travaux acquis à produire, et du nombre de logement maximal de broches d'appui (40) pouvant être logées dans la section de logement de broches d'appui (42a), lorsqu'un ordre de production des multiples travaux à produire acquis par la section d'acquisition de travail est déterminé, dans lequel
la section de détermination de plan de logement est configurée pour déterminer le nombre de broches d'appui (40) logées dans la section de logement de broches d'appui (42a) avant le début de la production de chacun des multiples travaux acquis à produire de manière à minimiser le nombre d'opérations par rapport à la section de logement de broches d'appui (42a), avant le début de la production d'un premier travail à produire jusqu'à la fin de la production d'un dernier travail à produire par rapport aux multiples travaux acquis à produire.

2. Dispositif de détermination selon la revendication 1, dans lequel
la section d'acquisition de nombre de logement maximal est configurée pour acquérir le nombre de logement maximal de broches d'appui (40) pouvant être logées dans la section de logement de broches d'appui (42a) dans le travail à produire pour chaque travail à produire acquis par la section d'acquisition de travail, et
la section de détermination de plan de logement est configurée pour déterminer le nombre de broches d'appui (40) logées dans la section de logement de broches d'appui (42a) avant le début de la production de chacun des multiples travaux acquis à produire sur la base du nombre requis de broches d'appui (40) requises dans chacun des multiples travaux acquis à produire et du nombre de logement maximal de broches d'appui (40) pouvant être logées dans la section de logement de broches d'appui (42a) dans chacun des multiples travaux acquis à produire.

3. Dispositif de détermination selon la revendication 1 ou 2, dans lequel
les broches d'appui (40) comprennent plusieurs types de broches d'appui (40),
les multiples travaux à produire définissent, pour chaque travail à produire, le nombre requis de différents types de broches d'appui (40) requises dans le travail à produire,
la section d'acquisition de nombre de logement maximal est configurée pour acquérir une somme des nombres de différents types de broches d'appui (40) pouvant être logées dans la section de logement de broches d'appui (42a), et la section de détermination de plan de logement est configurée pour déterminer le nombre de chacun des différents types de broches d'appui (40) logées dans la section de logement de broches d'appui (42a) avant le début de la production de chacun des multiples travaux acquis à produire.

4. Dispositif de détermination selon la revendication 2, dans lequel
la section d'acquisition de travail acquiert n travaux à produire,
un i-ème travail (i = 1 à n) à produire définit un nombre requis xi de broches d'appui (40) dans le i-ème travail à produire,
la section d'acquisition de nombre de logement maximal est configurée pour acquérir un nombre de logement maximal yi de broches d'appui (40) dans le i-ème travail à produire, et
la section de détermination de plan de logement
(1) est configurée pour déterminer si un nombre X de broches d'appui (40) requis pour le (i+1)ème travail et les travaux suivants à produire peut être logé dans la section de logement de broches d'appui (42a) dans l'ordre à partir du (i+1)ème travail à produire lorsque yi ≧xi, et
(2) est configurée pour établir un nombre maximal parmi xi à xi+j comme nombre de logement pour les travaux à produire à partir du i-ème travail à produire jusqu'à un (i+j)ème (j = 0 à m, 0 ≦ m ≦ n) travail à produire à partir du i-ème travail à produire lorsqu'il est déterminé que le nombre de broches d'appui (40) requis jusqu'au (i+j)ème travail à produire à partir du i-ème travail à produire dans la section de logement de broches d'appui (42a) peut être logé dans la section de logement de broches d'appui (42a).

5. Dispositif de détermination selon l'une quelconque des revendications 1 à 4, dans lequel le dispositif de montage de composants (10) comprend en outre une plaque d'appui qui supporte la broche d'appui (40),
la section de logement de broches d'appui (42a) et la section de disposition de broches d'appui (42b) sont définies sur la plaque d'appui, et
la section de détermination de plan de logement est configurée pour déterminer une région de chevauchement qui chevauche la carte dans la section de disposition de broches d'appui (42b) et pour déterminer une région de non-chevauchement qui ne chevauche pas la carte dans la section de logement de broches d'appui (42a) lorsque la carte est supportée par la broche d'appui (40).

6. Dispositif de détermination selon la revendication 5, dans lequel
le dispositif de montage de composants (10) comprend en outre une paire de goulottes pour transporter la carte,
la paire de goulottes comporte une goulotte fixe et une goulotte mobile qui est mobile par rapport à la goulotte fixe,
la section de logement de broches d'appui (42a) est prévue entre la goulotte fixe et la goulotte mobile, et la section de détermination de plan de logement est configurée pour déterminer le plan de logement de sorte que les broches d'appui (40) qui ne sont pas utilisées pour le support de la carte soient logées sur un côté de goulotte fixe dans un intervalle entre la goulotte mobile et la goulotte fixe dans la région de non-chevauchement.

7. Dispositif de montage de composants (10) comprenant :
une machine de montage configurée pour monter un composant sur une carte ; et
le dispositif de détermination selon l'une quelconque des revendications 1 à 6.

8. Procédé de détermination pour déterminer un plan de logement pour loger des broches d'appui (40) dans une section de logement de broches d'appui (42a) dans un dispositif de montage de composants (10) qui comprend la section de logement de broches d'appui (42a), une section de disposition de broches d'appui (42b), et un mécanisme de déplacement (18), dispose les broches d'appui (40) logées dans la section de logement de broches d'appui (42a) en déplaçant les broches d'appui (40) vers une position de support de carte sur la section de disposition de broches d'appui (42b) par le mécanisme de déplacement (18), et monte un composant sur une carte supportée en utilisant les broches d'appui (40), dans lequel la section de logement de broches d'appui (42a) est une région dans laquelle la broche d'appui (40) qui n'est pas utilisée pour supporter la carte est logée, et la section de disposition de broches d'appui (42b) est une région dans laquelle la broche d'appui (40) utilisée pour supporter la carte est installée, le procédé amenant un ordinateur à exécuter les processus suivants, comprenant :
un processus d'acquisition de travail consistant à acquérir un travail à produire pour définir un type de la carte sur laquelle le composant est monté, et un nombre requis de broches d'appui (40) devant être requises pour supporter le type de la carte ;
un processus d'acquisition de nombre de logement maximal consistant à acquérir un nombre de logement maximal de broches d'appui pouvant être logées dans la section de logement de broches d'appui (42a) dans le travail ;
**caractérisé par**
un processus de détermination de plan de logement consistant à déterminer le nombre de broches d'appui (40) à loger dans la section de logement de broches d'appui (42a) avant de commencer la production de chacun des multiples travaux acquis à produire sur la base du nombre requis de broches d'appui (40) requis dans chacun des multiples travaux acquis à produire et du nombre de logement maximal de broches d'appui (40) pouvant être logées dans la section de logement de broches d'appui (42a) lors d'un ordre de production des multiples travaux à produire, dans lequel
le processus de détermination de plan de logement détermine le nombre de broches d'appui (40) logées dans la section de logement de broches d'appui (42a) avant le début de la production de chacun des multiples travaux acquis à produire de manière à minimiser le nombre d'opérations par rapport à la section de logement de broches d'appui (42a), avant le début de la production d'un premier travail à produire jusqu'à la fin de la production d'un dernier travail à produire par rapport aux multiples travaux acquis à produire.
